(19) **Europäisches Patentamt / European Patent Office / Office européen des brevets**

(11) **EP 3 076 551 B1**

(12) **EUROPEAN PATENT SPECIFICATION**

(45) Date of publication and mention
of the grant of the patent:
**22.08.2018 Bulletin 2018/34**

(51) Int Cl.:
**H03K 17/73** *(2006.01)*　　**H03K 17/0814** *(2006.01)*

(21) Application number: **16163180.9**

(22) Date of filing: **31.03.2016**

(54) **A METHOD FOR CONTROL OF A VOLTAGE ON TERMINALS OF A POWER SEMICONDUCTOR IN AN ELECTRIC POWER CIRCUIT AND ELECTRIC POWER CIRCUIT**

VERFAHREN ZUR STEUERUNG EINER SPANNUNG AUF ENDGERÄTEN EINES LEISTUNGSHALBLEITERS IN EINER ELEKTRISCHEN SCHALTUNG UND ELEKTRISCHE STROMSCHALTUNG

PROCÉDÉ DE COMMANDE D'UNE TENSION SUR LES BORNES D'UN SEMI-CONDUCTEUR DE PUISSANCE DANS UN CIRCUIT D'ALIMENTATION ÉLECTRIQUE ET CIRCUIT D'ALIMENTATION ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.04.2015 IT BO20150160**

(43) Date of publication of application:
**05.10.2016 Bulletin 2016/40**

(73) Proprietor: **Energy Technology S.r.l.**
**40056 Valsamoggia (IT)**

(72) Inventors:
- **TADDIA, Giuseppe**
  **40066 PIEVE DI CENTO (BOLOGNA) (IT)**
- **TENCONI, Sandro Maria**
  **20144 MILANO (IT)**

(74) Representative: **Milli, Simone et al**
**Bugnion S.p.A.**
**Via di Corticella, 87**
**40128 Bologna (IT)**

(56) References cited:
**EP-A1- 0 509 118　　JP-A- 2005 277 858**

**Description**

The invention relates to a method for controlling the voltage at the terminals of a semiconductor in an electric power circuit and an electric power circuit.

Electronic apparatuses are known in the power electronics sector having power circuits equipped with semiconductors (in particular IGCT) used substantially with the function of unidirectional switches.

All the switches (whether they are solid state or electro-mechanical) have the phenomenon of overvoltage at opening, these overvoltages being caused by the magnetic energy stored in the inductance of the mesh which the switch interrupts.

It should be noted that there are overvoltages in these circuits, in particular during the "cut-off" (inhibiting) of the semiconductors, that is to say, voltages higher than the supply voltage.

These overvoltages are due basically to the high cut-off current derivatives of the power semiconductors and the inductances present in the switching mesh. Moreover, these overvoltages can also be due to the parasitic inductances or unwanted capacitance present in the circuits.

Since these voltages would also be destructive for components with high maximum block voltages, according to a first solution a so-called "snubber" circuit is normally installed in parallel to the switch, consisting of a diode, a capacitor and a resistance which "slow down" the lowering of the current in the main circuit.

In these circuits, it should also be noted that the capacity of the circuit constituting the "snubber" circuit must not be excessive so as not to excessively increase the switching the time of the semiconductors. According to a second solution, as an alternative to the "snubber" circuit, there is in parallel to the semiconductor/switch a protective device of the "clamp" type designed to control, that is to say, limit, the operating voltage of the semiconductors.

The clamp circuit generally consists of a circuit consisting of a diode and a source of low impedance voltage (generally a high capacity capacitor loaded at a predetermined voltage). However, also in this case, the mesh of the clamp circuit has in turn a not insignificant parasitic inductance, made worse by the inductive behaviour of the high voltage diode, which enters into conduction with a certain delay (phenomenon known as "forward recovery"). Even in the presence of these protective devices, significant overvoltages are still substantially found at the terminals of the semiconductor, in particular during transients.

Normally, therefore, the semiconductor is used at operating voltages which are significantly less than the maximum voltages which can be borne by the component, that is to say, an over-sized semiconductor is used in the circuit. There is therefore a strongly felt need of protecting the semiconductor of these electric circuits, so as to avoid overvoltages on the semiconductor (in particular in the transients) which can cause damage.

The need is also felt in the sector in question of adjusting in a particularly accurate and precise manner the voltage present on the semiconductor during switching off, to be able to use the semiconductor at operating voltages close to those maximum operating voltages of the component.

Document EP0509118 discloses a circuit arrangement with series-connected GTO components which is simplified and the dimensions of the circuit components are reduced due to the fact that the differences in the switching delay times td of the individual GTO components are reduced to a non-critical dimension by employing a "hard" drive by means of suitable gate units.

The aim of this invention is to satisfy the above-mentioned need, in particular to provide an electric power circuit comprising a semiconductor and a method for controlling the voltage of a semiconductor in an electric power circuit. The technical characteristics of the invention, with reference to the above aims, are clearly described in the claims below, while the invention is limited by the independent claims. Its advantages are apparent from the detailed description which follows, with reference to the accompanying drawings which illustrate a preferred embodiment of the invention provided merely by way of example without restricting the scope of the inventive concept, and in which:

- Figure 1 is a schematic view of an embodiment of the electric power circuit according to this invention;
- Figure 2 is a schematic view of the trend of the voltage at the ends of the electric power circuit according to the invention during the passage from a conduction condition to a cut-off condition;
- Figures 3 to 5 illustrate respective embodiments of the electric circuit according to the invention;

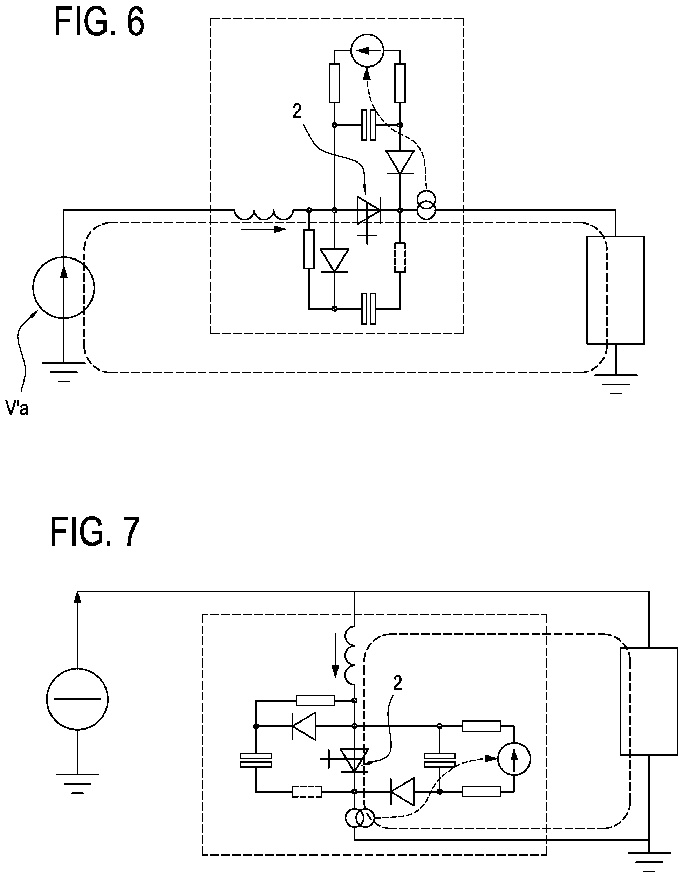

- Figures 6 and 7 illustrate two respective application diagrams of the electric circuit of Figure 4 (Figure 6 series switch, Figure 7 parallel or bypass switch).

With reference to the accompanying drawings, the numeral 1 denotes an electric power circuit according to this invention.

The electric circuit is equipped with a power semiconductor 2, defining a unidirectional switch.

The power semiconductor device 2 is preferably, but without restricting the scope of the invention, an Integrated Gate-Commutated Thyristor (known by the acronym IGCT).

The semiconductor device 2 is designed to be switchable between a conduction state (in which the passage of current through the semiconductor device 2 is allowed) and an inhibiting state (in which the passage of current through the semiconductor device 2 is prevented). More specifically, the semiconductor device 2 comprises a first and a second terminal 2A, 2B, through which the passage of current is allowed or prevented, in the conduction or inhibiting states, respectively.

This power circuit 1 is designed to be integrated in an electric power apparatus (of any type). The electric power circuit 1, comprises:

- a power semiconductor 2 subjected to a supply voltage V'a defining a unidirectional switch;
- a snubber device 5 associated (operatively, that is, electrically) with the power semiconductor 2 to limit the time derivative of the voltage Va present between the first and the second terminal 2A, 2B (during opening of the switch, that is, in the passage from the conduction state to the cut-off state) to a first predetermined limit value;

   - - a clamp device 3 electrically associated to the power semiconductor 2 for limiting the voltage Va present between the first and the second terminal 2A, 2B to a second predetermined limit value;

- a regulating power supply 4 associated to the clamp device 3, for making a control voltage Vc available to the clamp device 3, so as to regulate the second predetermined limit value.

As mentioned above, the power semiconductor 2 is equipped with a first connector 2A (hereinafter also referred to as terminal 2A) and a second connector 2B (hereinafter also referred to as terminal 2B) to which the supply voltage V'a is applied (that is, the voltage to which the semiconductor is subjected, more specifically, during the cut-off state). Preferably, but without restricting the scope of the invention, the first connector 2A and the second connector 2B are defined, respectively, by the anode and by the cathode of the semiconductor 2.

In accordance with the above, the snubber device 5 is connected both to the first connector 2A and the second connector 2B of the semiconductor 2.

As illustrated, the snubber device 5 comprises (at least) a diode 6, a capacitance 7 and a resistance 8.

It should be noted that the function of the snubber device 5 is essentially that of limiting the time derivative of the voltage Va present between the terminals 2A and 2B (first and second terminal) to a first predetermined limit value, that is to say, preventing the time derivative of the voltage Va between the first and the second terminal 2A and 2B from exceeding a predetermined first limit value.

Basically, in use, the snubber device 5 is active during the electrical transients of the semiconductor 2, in particular during the passage from an activation condition (conduction) to a cut-off condition (inhibiting) by the semiconductor 2.

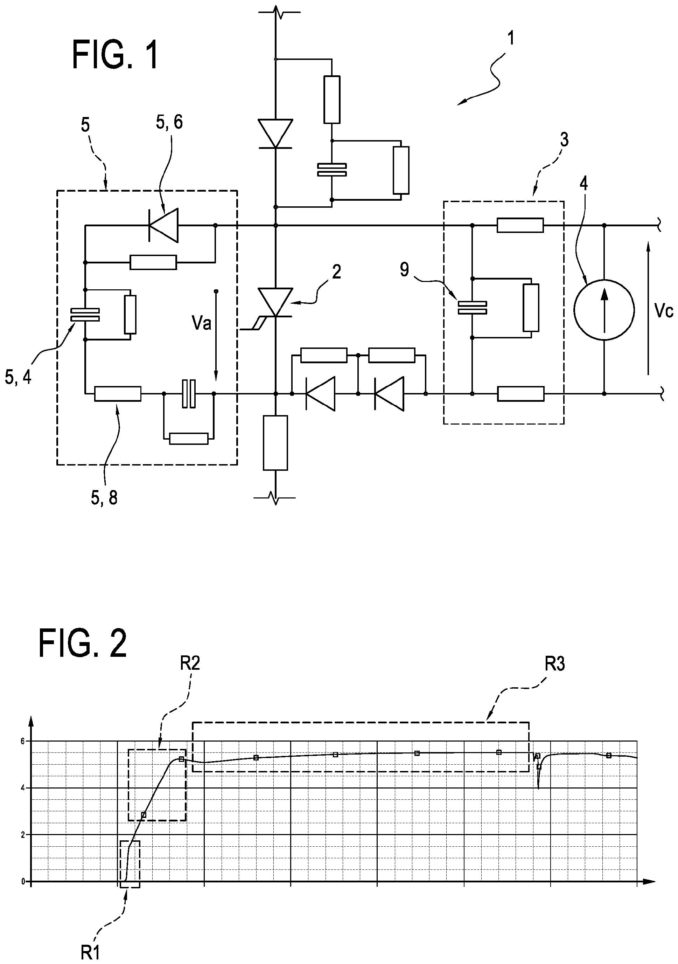

In this passage, from the activation condition (conduction) to the cut-off condition (inhibiting), the tension Va present at the terminals of the semiconductor 2 increases (as illustrated in Figure 2), and settles at steady-state on values close to the supply voltage V'a.

A region labelled R1 is indicated in Figure 2 in which the deactivation of the semiconductor 2 occurs and in which the snubber device 5 operatively takes over (as it is still not operatively active): Figure 2 shows how the snubber device 5 has not allowed in this first phase/region R1 the limiting (that is, keeping lower than a predetermined value) of the derivative of the voltage Va present between the terminals 2A and 2B at the region R1.

Current is transferred in the region R1 from the power semiconductor 2 to the snubber device 5, with a speed sets basically by the mechanism for switching off the semiconductor 2.

A (second) region labelled R2 is indicated in Figure 2 in which the deactivation of the semiconductor 2 has already been completed, and in which the snubber device 5 is operatively active: Figure 2 shows how the snubber device 5 has allowed in this first phase/region R2 the limiting (that is, keeping lower than a predetermined value) of the derivative of the voltage Va present between the terminals 2A and 2B.

It should be noted that the semiconductor 2 is preferably provided with at least one control input, to allow the state to be adjusted, that is, the condition of the semiconductor 2, between a switched off condition (inhibiting) and a switched on condition (conduction).

It should be noted that the power semiconductor 2 is equipped with a first connector 2A and a second connector 2B between which there is an instantaneous voltage Va (equal to Va during the deactivation state). Preferably, the clamp device 3 is connected to both the first connector 2A and the second connector 2B.

The clamp device 3 comprises at least a capacitance 9 (defined by one or more capacitors).

It should be noted that the regulating power supply 4 is connected to the at least one capacitance 9 of the clamp device 3 (for keeping the capacitance loaded at a control voltage Vc).

According to another aspect, the regulating power supply 4 is connected to the at least one capacitance 9 of the clamp device 3 through two resistors of adequate value which limit the current and therefore the power of the regulating power supply 4.

It should also be noted that, advantageously, the fact of combining a snubber device with a clamp device makes it possible to avoid overvoltages during the operation of the clamp.

A (third) region labelled R3 is indicated in Figure 2 in which the clamp device 3 is operatively active: the drawing shows how the clamp device 3 has allowed the limiting (that is, keeping lower than a predetermined value) of the voltage Va present between the terminals 2A and 2B at the third region R3.

It should be noted that energy is transferred to the clamp capacitor Cc in the region.

It should be noted that at the moment of operation of the clamp there are no longer overvoltages, since the transfer of the current from the snubber device 5 to the clamp device 3 is progressive.

In effect, the transfer of energy is controlled by the difference in voltage between the snubber capacitor Cs and the clamp capacitor Cc (voltage which increases progressively, as the voltage on the snubber capacitor Cs increases beyond the voltage of the clamp capacitor operation Vc).

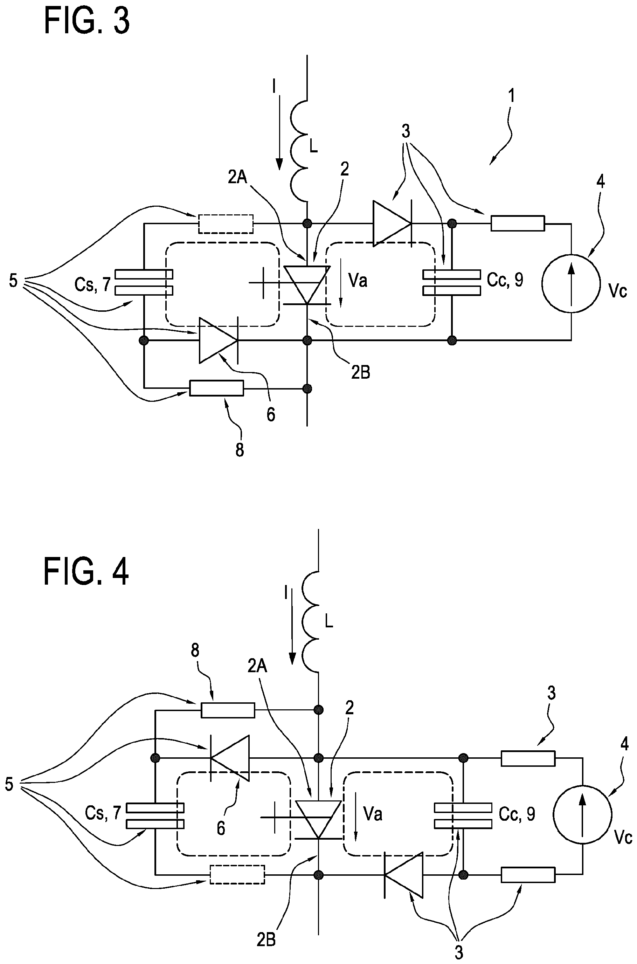

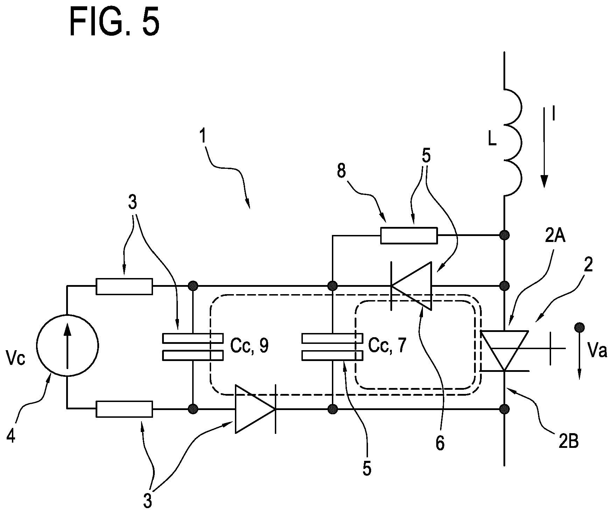

Moreover, the transfer of energy is also controlled by the parasitic inductance of the two meshes, denoted with a dashed line in Figures 3, 4 and 5.

It should be noted - as already mentioned - that between the first region R1 and the third region R3 there is a second region R2, in which there is an increase in the voltage in the snubber circuit 5, until reaching the clamp voltage Vc.

Advantageously, it is no longer necessary to use the power semiconductor at a voltage which is significantly less than the nominal voltage, that is, the design voltage of the semiconductor (from 30% to 50%, as is the case in prior art solutions).

In this case it is sufficient that the maximum voltage acting on the power semiconductor is less than the maximum repetitive peak permitted by the power semiconductor (IGCT).

According to another aspect, the charging voltage Vc of the clamp capacitor Cc can be based on the following formula (especially in the case of particularly high mesh inductances):

$$Vc = \sqrt{(1 + \frac{Cs}{Cc})V_{DM}^2 - \frac{L}{C_c} I^2}$$

Where:

- Cc represents the capacity of the snubber capacitor;
- Cc represents the capacity of the clamp capacitor
- $V_{dm}$ represents the maximum voltage at which the semiconductor 2 used with unidirectional switch operates;
- L represents the inductance of the mesh which interrupts the semiconductor 2 defining the switch;
- I represents the overall current circulating in the grid switching the semiconductor 2 defining the switch;

More specifically, this aspect is advantageous if:

- the semiconductor 2 defining the switch must intervene if a maximum permissible current I is exceeded;
- the value of the current I which the semiconductor 2 defining the switch must interrupt is known in advance;
- the direct current I has a relatively slow variation so that the load voltage of the clamp capacitor Cc may be related to the current I which flows in the switch 2.

Figures 3, 4 and 5 show alternative embodiments of the circuit according to the invention wherein the diodes, of the clamp device 3 and of the snubber device 5, respectively, are connected respectively to the anode and to the cathode of the semiconductor 2 defining the switch.

It should be noted that, advantageously, according to the invention, the combination of the clamp device with the snubber device makes it possible to reduce the parasitic inductances to a minimum.

The invention also relates to a method for controlling the voltage of a semiconductor 2 in an electric power circuit 1 according to independent method claim 5. The method comprises the following steps:

- - predisposing an electric circuit 1 comprising a power semiconductor 2 having a first terminal 2A and a second terminal 2B, with the semiconductor 2 defining a unidirectional switch designed to be switchable between a conduction step and a cut-off step;

- making a voltage V'a available between the first and the second terminal 2A, 2B of the semiconductor 2;
- controlling the voltage Va present between the first and the second terminal 2A, 2B of the semiconductor 2 during the passage from the conduction state to the cut-off state of the semiconductor 2 according to the following steps:

- limiting a time derivative of the voltage Va present between the terminals 2A, 2B to a lower value than a first predetermined limit value;
- limiting the voltage Va present between the terminals 2A and 2B of the semiconductor 2 to a second predetermined limit value. The step of limiting the voltage between the terminals 2A and 2B to a second predetermined limit value comprises the steps of:

- preparing a clamp device 3 and a feeder device 4;
- connecting the supply device 4 to the clamp device 3 for feeding the clamp device 3 using a control voltage Vc;
- regulating the control voltage Vc for limiting the voltage Va present between the terminals 2A, 2B to a second predetermined limit value.

The step of regulating the control voltage Vc for limiting the voltage Va present between the terminals 2A, 2B to a second predetermined limit value comprises a step of regulating the control voltage Vc according to a desired maximum voltage between the terminals 2A, 2B. The method comprises a step for positioning a "snubber" device 5 for limiting a time derivative of the voltage Va to a lower value than a first predetermined limit value. Advantageously, according to the method illustrated, it is possible to avoid overvoltages on the semiconductor 2 during the transients.

Consequently, in the absence of overvoltages acting on the semiconductor 2, it is possible to use a semiconductor having a failure voltage close to the maximum supply voltage Va, instead of being forced to use (according to the prior art) an over-sized semiconductor, that is to say, having a failure voltage much higher than the maximum voltage which can be reached Va (since a safety margin was necessary in the prior art to prevent a failure of the device).

An electric circuit is provided according to the invention which is particularly simple, highly reliable and inexpensive.

**Claims**

1. A method for control of a voltage of a power semiconductor (2) of an electric power circuit (1), comprising the following steps:

   - predisposing an electric circuit (1) comprising a power semiconductor (2) having at least a first terminal (2A) and a second terminal (2B), which semiconductor (2) is a unidirectional switch and is switchable between a conduction state and a blocking state;
   - making a voltage (Va) available between the first and the second terminal (2A, 2B) of the semiconductor (2) by a supply voltage (V'a);
   - controlling the voltage (Va) present between the first and the second terminal (2A, 2B) of the semiconductor (2) during the transition from the conduction state to the blocking state of the semiconductor (2) according to the following steps:
   - limiting a time derivative of the voltage (Va) present between the first and the second terminal (2A, 2B) to a lower value than a first predetermined limit value;
   - limiting the voltage (Va) present between the first and the second terminal (2A, 2B) to a second predetermined limit value by a snubber device (5); the method being **characterised in that** the step of limiting the voltage (Va) present between the first and the second terminal (2A, 2B) to said second predetermined limit value comprises steps of:

      - predisposing a clamp device (3) connected to the first and second terminal and having a predetermined capacitance (9);
      - predisposing a regulating power supply device (4);
      - connecting the regulating power supply device (4) to the capacitance (9) of the clamp device (3) in order to load the capacitance (9) at a control voltage (Vc);
      - regulating the control voltage (Vc) for limiting the voltage (Va) present between the first and the second terminal (2A, 2B) to said second predetermined limit value.

2. The method according to the preceding claim 1, wherein the step of regulating the control voltage (Vc) for limiting the voltage (Va) present between the first and the second terminal (2A, 2B) to said second predetermined limit value comprises a step of regulating the control voltage (Vc) according to a desired maximum admissible voltage between the first and the second terminal (2A, 2B).

3. The method according to claim 1, wherein the step of regulating the control voltage (Vc) comprises a step of regulating the control voltage (Vc) on the basis of the formula: control voltage

$$(Vc) = \sqrt{(1 + \frac{C_s}{C_c})V_{DM}^2 - \frac{L}{C_C}I^2}$$ , where:

- Cs represents the capacity of the snubber capacitor;
- Cc represents the capacity of the clamp capacitor;
- $V_{DM}$ represents the maximum supply voltage at which the semiconductor (2) operates;

- - L represents the inductance of a loop that the semiconductor (2) switches off;

- I represents the overall current circulating in the loop that the semiconductor (2) switches off.

4. The method according to any one of the preceding claims, comprising steps of:

- - predisposing said snubber device (5) for limiting a time derivative of the voltage (Va) present between the first and the second terminal (2A, 2B) to a value lower than a first predetermined limit value.

5. An electric circuit (1), comprising:

- a power semiconductor (2) having at least a first connector (2A) and a second connector (2B) connectable to a supply voltage (V'a) and defining a unidirectional switch;
- a snubber device (5) connected to the first and the second connector (2A, 2B) of the power semiconductor (2) for limiting a time derivative of a voltage (Va) present between the first and the second terminal (2A, 2B) to a lower value than a first predetermined limit value;
- a clamp device (3) connected to the first and the second connector (2A, 2B) of the power semiconductor (2) for limiting the voltage (Va) present between the first and the second terminal (2A, 2B) to a second predetermined limit value;
- a regulating power supply (4) connected to the clamp device (3), for making a control voltage (Vc) available to the clamp device (3), so as to regulate the second predetermined limit value.

6. The electric circuit according to claim 5, wherein the snubber device (5) comprises a diode (6), a capacitance (7) and a resistance (8) electrically connected to one another.

7. The electric circuit according to any one of the preceding claims from 5 to 6, wherein the clamp device (3) comprises at least a capacitance (9).

8. The electric circuit according to the preceding claim, wherein the regulating power supply (4) is electrically connected to the at least a capacitance (9) of the clamp device (3), for charging the capacitance (9).

9. The electric circuit according to any one of claims 5 to 8, wherein the semiconductor (2) is an Integrated Gate-Commutated Thyristor.


**Patentansprüche**

1. Verfahren zur Steuerung einer Spannung eines Leistungshalbleiters (2) einer elektrischen Stromschaltung (1), umfassend die folgenden Schritte:

- Vorbereiten einer elektrischen Schaltung (1), die einen Leistungshalbleiter (2) mit mindestens einem ersten Endgerät(2A) und einem zweiten Endgerät (2B) umfasst, wobei der Halbleiter (2) ein unidirektionaler Schalter ist und zwischen einem Leitungszustand und einem Sperrzustand umschaltbar ist;
- Stellen einer Spannung (Va) zwischen dem ersten und dem zweiten Endgerät (2A, 2B) des Halbleiters (2) durch eine Versorgungsspannung (V'a) zur Verfügung;
- Steuern der Spannung (Va), die zwischen dem ersten und dem zweiten Endgerät (2A, 2B) des Halbleiters (2) während des Übergangs vom Leitungszustand in den Sperrzustand des Halbleiters (2) vorhanden ist, gemäß den folgenden Schritten:

- Begrenzen einer zeitlichen Ableitung der Spannung (Va), die zwischen dem ersten und dem zweiten Endgerät (2A, 2B) auf einen Wert vorhanden ist, der niedriger als ein erster vorbestimmter Grenzwert ist;

- Begrenzen der zwischen dem ersten und dem zweiten Endgerät (2A, 2B) vorhandenen Spannung (Va) auf einen zweiten vorbestimmten Grenzwert durch eine Snubbervorrichtung (5); wobei das Verfahren **dadurch gekennzeichnet ist, dass** der Schritt des Begrenzens der zwischen dem ersten und dem zweiten Endgerät (2A, 2B) vorhandenen Spannung (Va) auf den zweiten vorbestimmten Grenzwert die folgenden Schritte umfasst:

- Vorbereiten einer Klemmvorrichtung (3), die mit dem ersten und zweiten Endgerät verbunden ist und eine vorbestimmte Kapazität (9) aufweist;

- Vorbereiten einer Regelstromversorgungsvorrichtung (4) ;

- Verbinden der Regelstromversorgungsvorrichtung (4) mit der Kapazität (9) der Klemmvorrichtung (3), um die Kapazität (9) mit einer Steuerspannung (Vc) zu belasten;

- Regeln der Steuerspannung (Vc) zur Begrenzung der zwischen dem ersten und dem zweiten Endgerät (2A, 2B) vorhandenen Spannung (Va) auf den zweiten vorbestimmten Grenzwert.

2. Verfahren nach dem vorhergehenden Anspruch 1, wobei der Schritt des Regelns der Steuerspannung (Vc) zur Begrenzung der zwischen dem ersten und dem zweiten Endgerät (2A, 2B) vorhandenen Spannung (Va) auf den zweiten vorbestimmten Grenzwert einen Schritt des Regelns der Steuerspannung (Vc) gemäß einer gewünschten maximal zulässigen Spannung zwischen dem ersten und dem zweiten Endgerät (2A, 2B) umfasst.

3. Verfahren nach Anspruch 1, wobei der Schritt des Regelns der Steuerspannung (Vc) einen Schritt des Regelns der Steuerspannung (Vc) auf der Basis der Formel umfasst: Steuerspannung

$$(\mathrm{Vc}) = \sqrt{\left(1 + \frac{C_s}{C_c}\right) V_{DM}^2 - \frac{L}{C_c} I^2},$$ wobei:

- Cs die Kapazität des Snubber-Kondensators darstellt
- Cc die Kapazität des Klammerkondensators darstellt;
- $V_{DM}$ die maximale Versorgungsspannung darstellt, bei der der Halbleiter (2) arbeitet;
- L die Induktivität einer Schleife darstellt, die der Halbleiter (2) abschaltet;
- I den Gesamtstrom darstellt, der in der Schleife zirkuliert, den der Halbleiter (2) abschaltet.

4. Verfahren nach einem der vorhergehenden Ansprüche, umfassend die Schritte von:

- Vorbereiten der Snubbervorrichtung (5) zur Begrenzung einer zeitlichen Ableitung der zwischen dem ersten und dem zweiten Endgerät (2A, 2B) vorhandenen Spannung (Va) auf einen Wert, der niedriger als ein erster vorbestimmter Grenzwert ist.

5. Elektrische Schaltung (1), umfassend:

- einen Leistungshalbleiter (2) mit mindestens einem ersten Verbinder (2A) und einem zweiten Verbinder (2B), die mit einer Versorgungsspannung (V'a) verbindbar sind, und der einen unidirektionalen Schalter definiert;

- eine Snubbervorrichtung (5), die mit dem ersten und dem zweiten Verbinder (2A, 2B) des Leistungshalbleiters (2) zur Begrenzung einer zeitlichen Ableitung einer zwischen dem ersten und dem zweiten Endgerät (2A, 2B) vorhandenen Spannung (Va) auf einen Wert verbunden ist, der niedriger als ein erster vorbestimmter Grenzwert ist;

- eine Klemmvorrichtung (3), die mit dem ersten und dem zweiten Verbinder (2A, 2B) des Leistungshalbleiters (2) zur Begrenzung der zwischen dem ersten und dem zweiten Endgerät (2A, 2B) vorhandene Spannung (Va) auf einen zweiten vorbestimmten Grenzwert verbunden ist;

- eine mit der Klemmvorrichtung (3) verbundene Regelstromversorgung (4), um der Klemmvorrichtung (3) eine Steuerspannung (Vc) zur Verfügung zu stellen, sodass der zweite vorbestimmte Grenzwert geregelt wird.

6. Elektrische Schaltung nach Anspruch 5, wobei die Snubbervorrichtung (5) eine Diode (6), eine Kapazität (7) und einen Widerstand (8) umfasst, die elektrisch miteinander verbunden sind.

7. Elektrische Schaltung nach einem der vorhergehenden Ansprüche 5 bis 6, wobei die Klemmvorrichtung (3) mindestens eine Kapazität (9) umfasst.

**8.** Elektrische Schaltung nach dem vorhergehenden Anspruch, wobei die Regelstromversorgung (4) mit der mindestens einen Kapazität (9) der Klemmvorrichtung (3) zum Laden der Kapazität (9) elektrisch verbunden ist.

**9.** Elektrische Schaltung nach einem der Ansprüche 5 bis 8, wobei der Halbleiter (2) ein integrierter Gate-Kommutierter Thyristor ist.

**Revendications**

**1.** Procédé de commande d'une tension d'un semi-conducteur (2) de puissance d'un circuit d'alimentation électrique (1), comprenant les étapes suivantes :

- prédisposer un circuit électrique (1) comprenant un semi-conducteur (2) de puissance comportant au moins une première borne (2A) et une seconde borne (2B), ledit semi-conducteur (2) est un commutateur unidirectionnel pouvant commuter entre un état de conduction et un état de blocage ;
- rendre disponible une tension (Va) entre la première et la seconde borne (2A, 2B) du semi-conducteur (2) par une tension d'alimentation (V'a) ;
- commander la tension (Va) présente entre la première et la seconde borne (2A, 2B) du semi-conducteur (2) pendant la transition de l'état de conduction à l'état de blocage du semi-conducteur (2) selon les étapes suivantes :
- limiter une dérivée temporelle de la tension (Va) présente entre la première et la seconde borne (2A, 2B) à une valeur inférieure à une première valeur limite prédéterminée ;
- limiter la tension (Va) présente entre la première et la seconde borne (2A, 2B) à une seconde valeur limite prédéterminée par un dispositif amortisseur (5) ; le procédé étant **caractérisé en ce que** l'étape de limitation de la tension (Va) présente entre la première et la seconde borne (2A, 2B) à ladite seconde valeur limite prédéterminée comprend les étapes de :
- prédisposer un serre-fil (3) raccordé à la première et à la seconde borne et comportant une capacitance prédéterminée (9) ;
- prédisposer un dispositif de réglage d'alimentation en énergie (4) ;
- raccorder le dispositif de réglage d'alimentation en énergie (4) à la capacitance (9) du serre-fil (3) afin de charger la capacitance (9) à une tension de commande (Vc) ;
- régler la tension de commande (Vc) pour limiter la tension (Va) présente entre la première et la seconde borne (2A, 2B) à ladite seconde valeur limite prédéterminée.

**2.** Procédé selon la revendication précédente 1, dans lequel l'étape consistant à régler la tension de commande (Vc) pour limiter la tension (Va) présente entre la première et la seconde borne (2A, 2B) à ladite seconde valeur limite prédéterminée comprend une étape consistant à régler la tension de commande (Vc) selon une tension maximale admissible désirée entre la première et la seconde borne (2A, 2B).

**3.** Procédé selon la revendication 1, dans lequel l'étape consistant à régler la tension de commande (Vc) comprend une étape de réglage de la tension de commande (Vc) sur la base de la formule : tension de commande

$$(Vc) = \sqrt{(1 + \frac{Cs}{Cc})V_{DM}^2 - \frac{L}{C_c}I^2}, \text{ où :}$$

- Cs représente la capacité du condensateur d'amortissement ;
- Cc représente la capacité du condensateur du serre-fil ;
- $V_{DM}$ représente la tension d'alimentation maximale à laquelle le semi-conducteur (2) fonctionne ;
- L représente l'inductance d'une boucle que le semi-conducteur (2) coupe ;
- I représente le courant total circulant dans la boucle que le semi-conducteur (2) coupe ;

**4.** Procédé selon l'une quelconque des revendications précédentes, comprenant les étapes de :

- prédisposer ledit dispositif amortisseur (5) pour limiter une dérivée temporelle de la tension (Va) présente entre la première et la seconde borne (2A, 2B) à une valeur inférieure à une première valeur limite prédéterminée ;

**5.** Circuit électrique (1) comprenant :

   - un semi-conducteur (2) de puissance comportant au moins un premier connecteur (2A) et un second connecteur (2B) pouvant se connecter à une tension d'alimentation (V'a) et définissant un commutateur unidirectionnel ;
   - un dispositif amortisseur (5) raccordé au premier et au second connecteur (2A, 2B) du semi-conducteur (2) de puissance pour limiter une dérivée temporelle d'une tension (Va) présente entre la première et la seconde borne (2A, 2B) à une valeur inférieure à une première valeur limite prédéterminée ;
   - un serre-fil (3) raccordé au premier et au second connecteur (2A, 2B) du semi-conducteur (2) de puissance pour limiter la tension (Va) présente entre la première et la seconde borne (2A, 2B) à une seconde valeur limite prédéterminée ;
   - une alimentation en énergie de réglage (4) raccordée au serre-fil (3) pour rendre disponible une tension de commande (Vc) au serre-fil (3) de manière à régler la seconde valeur limite prédéterminée.

**6.** Circuit électrique selon la revendication 5, dans lequel le dispositif amortisseur (5) comprend une diode (6), une capacitance (7) et une résistance (8) électriquement raccordées les unes aux autres.

**7.** Circuit électrique selon l'une quelconque des revendications précédentes de 5 à 6, dans lequel le serre-fil (3) comprend au moins une capacitance (9).

**8.** Circuit électrique selon la revendication précédente, dans lequel l'alimentation en énergie de réglage (4) est électriquement raccordée à au moins une capacitance (9) du serre-fil (3) pour charger la capacitance (9).

**9.** Circuit électrique selon l'une quelconque des revendications de 5 à 8, dans lequel le semi-conducteur (2) est un thyristor à commutation de porte intégrée.

# FIG. 1

# FIG. 2

# FIG. 3

# FIG. 4

# FIG. 5

# FIG. 6

V'a

# FIG. 7

**REFERENCES CITED IN THE DESCRIPTION**

**Patent documents cited in the description**

- EP 0509118 A